# EUROPÄISCHE PATENTSCHRIFT

(11) **EP 1 113 463 B1**
(45) Veröffentlichungstag und Bekanntmachung des Hinweises auf die Patenterteilung: **23.04.2008**
(21) Anmeldenummer: 00128583.2
(22) Anmeldetag: 27.12.2000
(51) Int. Cl.: H01F 21/12, H01F 17/00, H01F 41/04

(54) **Planare Induktivität und Herstellungsverfahren**
Planar inductor and manufacturing method
Inductivité plane et procédé de fabrication

(30) Priorität: 27.12.1999 DE 19963290
(43) Veröffentlichungstag der Anmeldung: 04.07.2001
(73) Patentinhaber: TridonicAtco GmbH & Co. KG, 6851 Dornbirn (AT)
(72) Erfinder: Ludorf, Werner, Dr., 6912 Hörbranz (AT)
(74) Vertreter: Rupp, Christian

(56) Entgegenhaltungen:
- EP-A- 0 654 802
- EP-A- 0 917 162
- DE-A- 3 941 323
- US-A- 5 532 667
- PATENT ABSTRACTS OF JAPAN vol. 011, no. 108 (E-495), 4. April 1987 (1987-04-04) & JP 61 256611 A (FUJITSU LTD), 14. November 1986 (1986-11-14)
- PATENT ABSTRACTS OF JAPAN vol. 011, no. 382 (E-564), 12. Dezember 1987 (1987-12-12) & JP 62 145806 A (MATSUSHITA ELECTRIC IND CO LTD), 29. Juni 1987 (1987-06-29)

## Beschreibung

Die vorliegende Erfindung betrifft eine planare Induktivität nach dem Oberbegriff des Anspruches 1. Eine derartige planare Induktivität ist nach den Patent Abstracts of Japan, Vol, 11, Nr.108 (E-495), 4. April 1987 & JP 61 256 611 A bekannt.

Im Rahmen der Bemühungen, elektronische Schaltungen immer kleiner und platzsparender zu gestatten, haben gedruckte Schaltkreise sowie Mehrlagenschaltungen in den letzten Jahren zunehmend an Bedeutung erlangt. In der Dickschichttechnologie werden Gold-, Silberlegierungs- oder Kupferpasten im Siebdruck auf eine Leiterplatte aufgebracht und anschließend zu Leiterbahnen eingebrannt. Die sog. LT-CC-(Low Temperatur Cofired Ceramic)-Technik stellt eine Weiterentwicklung der herkömmlichen Dickschichttechnologie dar. Dabei werden Leiterbahn-Muster auf niedrig sinternde grüne Keramikfolien aufgebracht und anschließend mehrere Keramikfolien übereinander angeordnet, laminiert und schließlich gemeinsam gebrannt.

In solchen Mehrlagenschaltungen können neben den üblichen Leiterbahnen auch Widerstände, Kapazitäten und Induktivitäten realisiert werden. Insbesondere durch die Verwendung sog. planarer Induktivitäten anstelle von herkömmlichen gewickelten Induktivitäten kann ein großer Raumgewinn erzielt werden. Dabei können solche planaren Induktivitäten auf unterschiedliche Weise gebildet werden. Eine sehr einfache Möglichkeit besteht beispielsweise darin, ein spiralen-artiges Leiterbahn-Muster auf eine Leiterplatten aufzudrucken, so daß sämtliche Windungen der Induktivität in einer gemeinsamen Ebene angeordnet sind. Bei der Verwendung von Mehrlagenschaltungen besteht andererseits auch die Möglichkeit, die einzelnen Windungen in Sandwich-Bauweise übereinander anzuordnen.

Im Gegensatz zu herkömmlichen Spulen kann eine solche integrierte Induktivität allerdings nachträglich nicht mehr ausgewechselt werden, beispielsweise um eine Spule mit einer größeren Windungszahl zu verwenden. In der EP 0 926 932 wird eine in eine Mehriagenschaltung integrierte Induktivität vorgeschlagen, welche aus mehreren übereinander angeordneten Windungen besteht, die jeweils ein äußeres und ein inneres Leiterbahn-Muster aufweisen. Durch Durchtrennen des äußeren Leiterbahn-Musters mittels Laserstrahlen kann der Beitrag der einzelnen Windungen zur gesamten Induktivität variiert werden. Allerdings muß dabei eine Beschädigung der zwischen den Leiterbahn-Ebenen angeordneten Trägerschichten in Kauf genommen werden, da in diese zum Durchtrennen des äußeren Leiterbahn-Musters Löcher eingebrannt werden müssen. Aus diesem Grund ist dieses Verfahren auch relativ zeitaufwendig. Da sich die Struktur des inneren und des äußeren Leiterbahn-Musters nur geringfügig unterscheidet, kann mit diesem Verfahren die Induktivität auch nur in einem relativ kleinen Bereich verändert werden.

Es ist daher Aufgabe der vorliegenden Erfindung, eine planare Induktivität für eine Leiterplatte oder eine Mehrlagenschaltung anzugeben, deren Induktivitätswert nachträglich in einem weiten Bereich auf einfache und schnelle Weise verändert werden kann.

Die Aufgabe wird durch eine Induktivität, welche die Merkmale des Anspruches 1 aufweist, gelöst. Sie zeichnet sich dadurch aus, daß die Abgleich-Abschnitte einen reduzierten Leiterbahn-Querschnitt aufweisen. Durch kurzfristiges Anlegen eines Überstromes können dann die Abgleich-Abschnitte gezielt weggebrannt werden, wie dies in Anspruch 2 beansprucht ist.

Im folgenden soll die Erfindung anhand der beiliegenden Zeichnungen näher erläutert werden. Es zeigen:
- Fig. 1: ein erstes Ausführungsbeispiel einer erfindungsgemäßen planaren Induktivität in Draufsicht;
- Fig. 2: eine perspektivische Darstellung der in Fig. 1 gezeigten planaren Induktivität;
- Fig. 3: ein zweites Ausführungsbeispiel einer erfindungsgemäßen planaren Induktivität;
- Fig. 4: ein drittes Ausführungsbeispiel einer erfindungsgemäßen planaren Induktivität; und
- Fig. 5: ein viertes Ausführungsbeispiel einer erfindungsgemäßen planaren Induktivität in perspektivischer Darstellung.

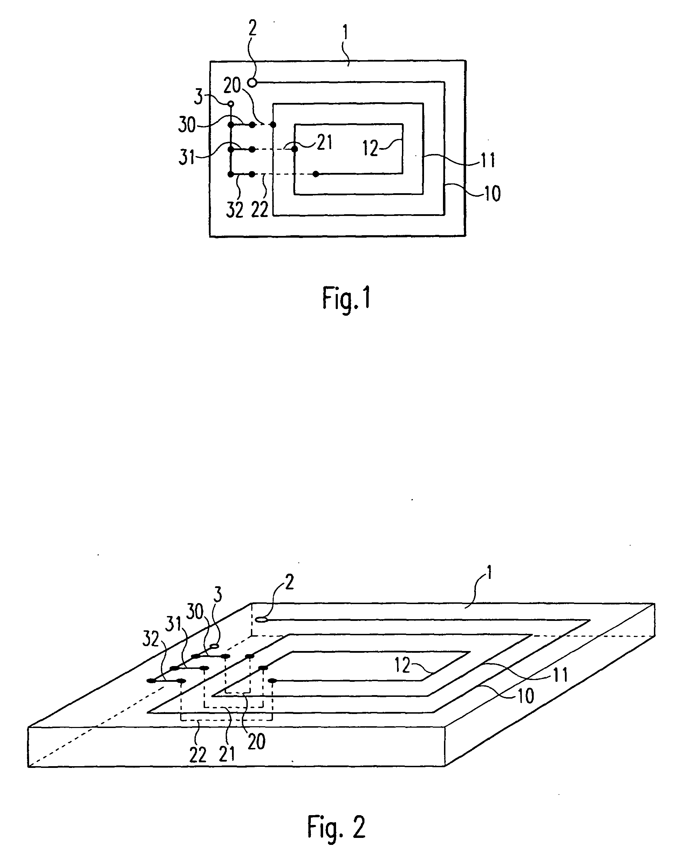

Bei der in den Fig. 1 und 2 dargestellten planaren Induktivität, die beispielsweise als Drossel oder als Primär- oder Sekundärwicklung eines planar integrierten Transformators Verwendung findet, sind sämtliche Windungen 10 bis 12 in einer gemeinsamen Ebene auf der Oberseite einer Trägerplatte 1 angeordnet. Bei dieser Trägerplatte 1 kann es sich beispielsweise um eine einzelne Leiterplatte oder aber auch um eine niedrig sinternde Keramikfolie, die Bestandteil einer LTCC-Mehrlagenschaltung ist, handeln. Die Induktivität wird in diesem Fall durch ein spiralen-artiges Leiterbahnmuster gebildet, das einen Anfangsanschluß 2 und eine Endanschluß 3 aufweist. Aus Gründen der Übersichtlichkeit weist die dargestellte Induktivität lediglich drei Windungen 10 bis 12 auf. Es können allerdingsinsbesondere auch bei Mehrlagenschaltungen in LTCC-Technik-wesentlich höhere Windungszahlen erzielt werden.

Die Windungszahl der planaren Induktivität kann im vorliegenden Beispiel in Einzelschritten verändert werden. Zu diesem Zweck ist jede einzelne Windung 10 bis 12 über eine entsprechende Anzapfungs-Leiterbahn 20 bis 22 mit dem Endanschluß 3 verbunden. Um Überschneidungen derAnzapfungs-Leiterbahnen 20 bis 22 mit den Windungen 10 bis 12 zu vermeiden, verlaufen die Anzapfungs-Leiterbahnen 20 bis 22 in einer anderen Leiterbahnebene. Handelt es sich bei der Trägerplatte 1 um eine einzelne Leiterplatte, bedeutet dies, daß diese Leiterplatte sowohl auf der Ober- als auch auf der Unterseite mit Leiterbahnen bedruckt ist. Bei einer Mehrlagenschaltung werden die entsprechenden Abschnitte der Anzapfungs-Leiterbahnen dann auf die Oberseite der darunter angeordneten Keramikfolie aufgebracht. Die unterschiedlichen Leiterbahnebenen sind durch vertikal verlaufende Durchkontaktierungslöcher miteinander verbunden, die vor dem Drucken der Leiterbahnen in die Trägerplatte 1 eingestanzt und mit einem leitfähigen Material gefüllt werden.

Zunächst sind sämtliche Anzapfungs-Leiterbahnen 20 bis 22 durchgängig. Dies bedeutet aber, daß die Anzapfungs-Leiterbahn 20 der ersten Windung 10 die beiden weiteren Windungen 11 und 12 kurzschließt, so daß lediglich die äußerste Windung 10 effektiv wirksam ist. Die Windungszahl kann nun erfindungsgemäß um eine Windung erhöht werden, indem der Abgleich-Abschnitt 30 der ersten Anzapfungs-Leiterbahn 20 durchtrennt wird. Als Folge davon schließt dann die zweite Anzapfungs-Leiterbahn 21 die dritte Windung 12 kurz. so daß nunmehr die Induktivität effektiv zwei Windungen aufweist. Durch ein weiteres Durchtrennen des Abgleich-Abschnittes 31 der zweiten Anzapfungs-Leiterbahn 21 kann dann die maximale Windungszahl eingestellt werden. Durch sukzessives Unterbrechen der Abgleich-Abschnitte 30, 31 kann somit die effektive Windungszahl der Induktivität in einfacher Weise vergrößert werden.

Das Durchtrennen der Abgleich-Abschnitte 30 bis 32 erfolgt nach dem Stand der Technik in einfachster Weise mittels Laserstrahlen. Zu diesem Zweck sind sämtliche Abgleich-Abschnitte 30 bis 32 an der Oberseite der Trägerplatte 1 - vorzugsweise parallel - angeordnet. Ist die Trägerplatte 1 Bestandteil einer LTCC-Mehrlagenschaltung, so handelt es sich dann um eine von außen zugängliche Keramikschicht, also entweder die oberste oder die unterste Schicht. Dabei besteht die Möglichkeit, während der Laserbestrahlung gleichzeitig ein Testsignal an die beiden Anschlüsse 2 und 3 anzulegen, so daß während des Durchtrennens der Abgleich-Abschnitte 30 bis 32 der sich dadurch ergebende Induktivitätswert oder allgemeiner auch das Impedanzverhalten der Schaltung bestimmt werden kann.

Nach der Erfindung erfolgt das Durchtrennen der Abgleich-Abschnitte 30 bis 32 dadurch dass, jeweils ein kurzer Strom mit einer hohen Stromstärke an die Anschlüsse 2 und 3 angelegt wird, so daß der gerade wirksame, d.h. der erste noch nicht durchtrennte Abgleich-Abschnitt aufgrund des Überstroms durchbrennt. Der Abgleich der Induktivität erfolgt dann dadurch, daß abwechselnd ein kurzer Überstrom angelegt wird und anschließend durch ein kurzes Testsignal die Induktivität bzw. das Impedanzverhalten bestimmt wird. Bei diesem Verfahren weisen die Abgleich-Abschnitte 30 bis 32 erfindungsgemäß einen etwas reduzierten Leiterbahn-Querschnitt auf. Der Vorteil dieser Lösung besteht darin, daß neben den Leiterbahnen für die Windungen und die Anzapfungs-Leiterbahnen auch diejenigen für die Abgleich-Abschnitte vollständig in eine Mehrlagenschaltung eingebettet werden können und somit vor äußeren Einflüssen geschützt sind. Allerdings kann auch bei dem zuvor beschriebenen Verfahren des Durchtrennens mittels Laserstrahlen eine Leiterbahn-Anordnung gewählt werden, bei der sich lediglich die Abgleich-Abschnitte 30 bis 32 an der Oberfläche der Mehrlagenschaltung befinden, während sämtliche anderen Leiterbahnen in anderen Ebenen der Mehrlagenschaltung angeordnet sind.

Das in den ersten beiden Figuren dargestellte Ausführungsbeispiel kann bezüglich der Anordnung der einzelnen Windungen selbstverständlich frei verändert werden. Insbesondere bei der Verwendung von Mehrlagenschaltungen kann jede Windung in einer einzelnen Ebene angeordnet werden, wobei sich der Querschnitt der Induktivität nicht verändert.

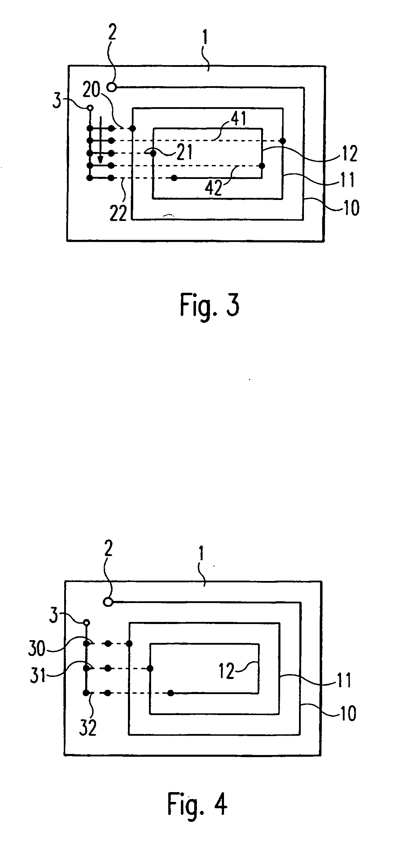

Bei dem ersten Ausführungsbeispiel kann die Windungszahl der Induktivität in Einzelschritten verändert werden. Weist eine planare Induktivität sehr viele Windungen auf, so ist es oftmals ausreichend, die Windungszahl in größeren Schritten zu verändern. Zu diesem Zweck kann dann vorgesehen sein, daß lediglich jede zweite oder dritte Windung über eine Anzapfungs-Leiterbahn mit dem Anschluß der Induktivität verbunden ist. Andererseits besteht die Möglichkeit, die Windungszahl nicht nur in ganzzahligen Schritten, sondern auch in Bruchteilen davon zu variieren. Dies ist in dem zweiten Ausführungsbeispiel in Fig. 3 dargestellt. Zu diesem Zweck ist eine einzelne Windung - beispielsweise die Windung 11 - an zwei Stellen über die Anzapfungs-Leiterbahnen 21 und 41 mit dem Endanschluß 3 der Induktivität verbunden. Auch hier sind die Abgteich-Abschnitte auf der Trägerplatte 1 vorzugsweise so angeordnet, daß bei einer sukzessiven Laserbestrahlung dieser Abschnitte in Pfeilrichtung die Induktivität in aufeinanderfolgenden Schritten erhöht wird.

Ein weiteres Ausführungsbeispiel einer planaren Induktivität ist in Fig. 4 dargestellt. In diesem Fall sind zunächst sämtliche Abgleich-Abschnitte 30 bis 32 unterbrochen, so daß sich im Ausgangszustand der Induktivität keine geschlossene Leiterbahn ergibt. Zum Einstellen der gewünschten Windungszahl kann dann der entsprechende Abgleich-Abschnitt durch Einlöten eines 0Ω-Widerstandes oder Aufdrucken einer Leiterbahn geschlossen werden. Dies setzt allerdings voraus, daß zwischen den einzelnen Abgleich-Abschnitten 30 bis 32 ein räumlicher Abstand besteht, der ausreichend groß ist, um das Schließen eines einzelnen Abgleich-Abschnittes technisch handhaben zu können. Die Anordnung der Windungen kann bei diesem Beispiel ebenfalls in einem weiten Bereich variiert werden. Einzige Bedingung ist, daß zumindest die Abgleich-Abschnitte 30 bis 32 frei zugänglich angeordnet sind.

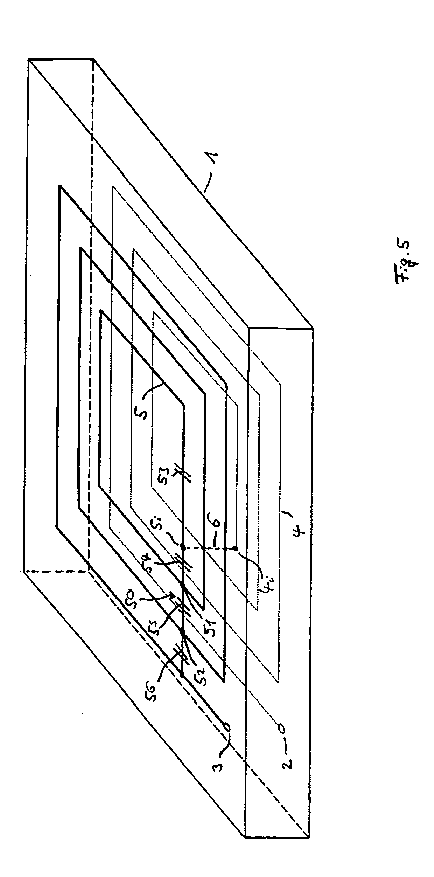

Im Gegensatz zu den in den Figuren 1 bis 4 dargestellten Beispielen ist bei dem in Fig. 5 dargestellten Ausführungsbeispiel lediglich eine einzige Anzapfungs-Leiterbahn vorgesehen, welche die weiteren Leiterbahnen der Induktivität kreuzt und diese somit kurzschließt. Dieses Ausführungsbeispiel ist insbesondere dazu geeignet, die Induktivitätswerte in sehr großen Schritten zu ändern.

Hierzu besteht die gesamte Induktivität aus mehreren in verschiedenen Ebenen angeordneten planaren Teil-Induktivitäten, im vorliegenden Beispiel aus einer auf der Unterseite der Trägerplatte 1 angeordneten ersten Teil-Induktivität 4 sowie aus einer auf der Oberseite angeordneten zweiten Teil-Induktivität 5, wobei beide Teil-Induktivitäten 4 und 5 durch spiralen-artige Leiterbahnmuster gebildet werden. Die inneren Endpunkte 4i und 5i der Teil-Induktivitäten 4 und 5 sind über eine vertikale Verbindungsleitung 6 miteinander verbunden; die äußeren Endpunkte bilden die Anschlüsse 2 und 3 der Gesamt-Induktivität.

Außer über die spiralen-artige Leiterbahn ist der innere Endpunkt 5i der oberen Teil-Induktivität 5 auch über eine Anzapfungs-Leiterbahn 50 direkt mit dem Anschluß 3 verbunden, wobei diese Anzapfungs-Leiterbahn 50 in der gleichen Ebene wie die Windungen der Induktivität 5 verläuft, diese daher an den Kreuzungspunkten 51 und 52 kreuzt und somit kurzschließt. Durch diese Kreuzungspunkte 51 und 52 wird die Anzapfungs-Leiterbahn 50 in mehrere Abschnitte unterteilt, die jeweils einen Abgleich-Abschnitt 54-56 aüfweisen. Ein weiterer Abgleich-Abschnitt 53 befindet sich in der innersten Windung der spiralen-artigen Leiterbahn.

Über ein entsprechendes Durchtrennen der verschiedenen Abgleich-Abschnitte 53-56 kann nun der Induktivitätswert verändert werden. So hat ein Durchtrennen der Abgleich-Abschnitte 54-56 zur Folge, daß das gesamte spiralen-artige Leiterbahn-Muster auf der Oberseite zur Gesamt-Induktivität beiträgt, so daß sich somit ein hoher Induktivitätswert ergibt. Soll hingegen eine niedrige Induktivität eingestellt werden, wird lediglich der Abgleich-Abschnitt 53 durchtrennt, so daß die Anzapfungs-Leiterbahn 50 vollständig durchgängig ist und den inneren Endpunkt 5i direkt mit dem Anschluß 3 verbindet. Zur Gesamt-Induktivität trägt dann nur die untere Teil-Induktivität 4 bei. Durch ein Durchtrennen einzelner Abgleich-Abschnitte kann die Induktivität allerdings auch in kleineren Schritten verändert werden.

Das vorliegende Beispiel ist insbesondere dann von Vorteil, wenn eine Gesamt-Induktivität durch mehrere in verschiedenen Ebenen angeordnete Teil-Induktivitäten gebildet wird, da hier auf einfache Weise eine Teil-Induktivität durch entsprechendes Durchtrennen der Abgleich-Abschnitte abgetrennt bzw. kurzgeschlossen und damit der Induktivitätswert in großen Schritten verändert werden kann. Das Durchtrennen der Abgleich-Abschnitte kann wiederum beispielsweise mittels Laserstrahlung oder Anlegen eines Überstroms erfolgen.

Derwesentliche Vorteil der vorliegenden Erfindung ist darin zu sehen, daß lediglich ein einmaliger Entwurf für die Leiterbahn-Struktur notwendig ist, der dennoch in einem großen Anwendungsbereich Verwendung finden kann. Solche planaren Induktivitäten können beispielsweise bei Schaltungen verwendet werden, die speziell für hohe Frequenzen vorgesehen sind. Dies ist insbesondere deswegen möglich, da bei Hochfrequenzen die Kapazitäts- und Induktivitätswerte reduziert werden können. Ein bevorzugtes Anwendungsbeispiel einer derartigen einstellbaren Induktivität ist beispielsweise eine elektronisches Vorschaltgerät, das Gasentladungslampen bei sehr hohen Frequenzen ansteuert. Insbesondere ist die Möglichkeit gegeben, das Vorschaltgerät nach der Fertigstellung abzugleichen, d. h. auf einem Prüfstand die Eigenschaften des Vorschattgerätes zu messen und während dessen eine bestimmte Leistung einzustellen. Die Leistung wird nämlich u.a. auch durch die Frequenz bestimmt, die ihrerseits durch die Größe der Induktivität und somit durch die Windungszahl festgelegt wird. Auf diese Weise kann gewährleistet werden, daß sämtliche Vorschaltgeräte einer bestimmten Produktionsreihe trotz möglicher Bauteil-Tolleranzen anderer Bauelemente die gleiche vorgegebene Leistung aufweisen. Es besteht auch die Möglichkeit, für Schaltungen unterschiedlicher Leistungen lediglich einen einzigen Entwurf zu verwenden, da in einfacher Weise die Leistung nachträglich eingestellt werden kann.

## Patentansprüche

1. Planare Induktivität mit zwei Endanschlüssen (2, 3) und mehreren Windungen (10-12) in Form von gedruckten Leiterbahnen auf mindestens einer Trägerplatte (1),
wobei mindestens zwei Windungen (10-12) mit dem gleichen Endanschluß (3) über separate durchtrennbare Anzapfungs-Leiterbahnen (20-22;53-56) verbunden sind,
**dadurch gekennzeichnet,**
**daß** die Anzapfungs-Leiterbahnen (20-22) Abgleich-Abschnitte (30-32) aufweisen, die einen reduzierten Leiterbahn-Querschnitt haben.

2. Verfahren zum Verändern einer planaren Induktivität mit zwei Endanschlüssen (2, 3) und mehreren Windungen (10-12) in Form von gedruckten Leiterbahnen auf mindestens einer Trägerplatte (1),
wobei die planare Induktivität ferner eine oder mehrere Anzapfungs-Leiterbahnen (20-22,53-56) aufweist, die zum Verändem der Induktivität durchtrennt werden,
**dadurch gekennzeichnet,**
**daß** die Anzapfungs-Leiterbahnen (20-22,53-56) Abgleich-Abschnitte (30-32) aufweise die einen reduzierten Leiterbahn-Querschnitt haben und daß diese Abgleich-Abschnitte (30-32) durch Anlegen eines Stromes mit geeigneter Stromstärke weggebrannt werden.

## Claims

1. Planar inductance with two end terminals (2, 3) and a plurality of windings (10-12) in the form of printed conductor paths on at least one carrier plate (1),
wherein at least two windings (10-12) are connected with the same end terminal (3) via separate severable tapping conductor paths (20-22; 53-56),
**characterised in that**,
the tapping conductor paths (20-22) have balancing sections (30-32) which have a reduced conductor path cross-section.

2. Method of varying a planar inductance with two end terminals (2, 3) and a plurality of windings (10-12) in the form of printed conductor paths on at least one carrier plate (1),
wherein the planar inductance further has one or a plurality of tapping conductor paths (20-22; 53-56) which are severed for varying the inductance,
**characterised in that**,
the tapping conductor paths (20-22; 53-56) have balancing sections (30-32) which have a reduced conductor path cross-section, and **in that** these balancing sections (30-32) are burned away by application of a current with a suitable current intensity.

## Revendications

1. Inductance plane avec deux branchements finaux (2,3) et plusieurs spires (10-12) en forme de pistes conductrices imprimées sur au moins une plaque support (1),
au moins deux spires (10-12) étant reliées au même branchement final (3) par des pistes conductrices de tirage (20-22, 53-56) séparées et pouvant être coupées,
**caractérisée en ce que**
les pistes conductrices de tirage (20-22) présentent des portions de régulation (30-32) ayant une section de piste conductrice réduite.

2. Procédé de modification d'une inductance plane avec deux branchements finaux (2,3) et plusieurs spires (10-12) en forme de pistes conductrices imprimées sur au moins une plaque support (1),
l'inductance plane présentant en outre une ou plusieurs pistes conductrices de tirage pouvant être coupées pour modifier l'inductance,
**caractérisé en ce que**
les pistes conductrices de tirage (20-22, 53-56) présentent des portions de régulation (30-32) ayant une section de piste conductrice réduite,
et **en ce que** ces portions de régulation (30-32) sont brûlées par l'application d'un courant électrique d'intensité appropriée.
